# EUROPEAN PATENT APPLICATION

(11) **EP 4 071 270 A1**
(43) Date of publication of application: **12.10.2022**
(21) Application number: 20895449.5
(22) Date of filing: 04.12.2020
(51) Int. Cl.: C23C 16/517

(54) **DLC PREPARATION APPARATUS AND PREPARATION METHOD**

(30) Priority: 04.12.2019 CN 201911227596
(71) Applicant: Jiangsu Favored Nanotechnology Co., Ltd., Yuqi Industry Park, Huishan District Wuxi Jiangsu 214000 (CN)
(72) Inventor: ZONG, Jian, Wuxi, Jiangsu 214112 (CN)
(74) Representative: Mewburn Ellis LLP
(86) International application number: PCT/CN2020/133768
(87) International publication number: WO 2021/110111

(57) **Abstract**

A DLC preparation apparatus and a preparation method. The DLC preparation apparatus comprises a body (10), a plasma source unit (50), and at least one gas supplying part (20). The body (10) is provided with a reaction chamber (100). The reaction chamber (100) is used for placing a substrate. The gas supplying part (20) is used for supplying a reaction gas to the reaction chamber (100). The plasma source unit (50) is provided outside of the body (10) and provides a radiofrequency electric field to the reaction chamber (100) to promote the generation of plasma, thus allowing the reaction gas to be deposited on the surface of the substrate by means of PECVD to form a DLC film.

## Description

### TECHNICAL FIELD

The present disclosure relates to the field of diamond-like carbon (DLC) preparation, and more particularly to an apparatus and a method for transparent and hard DLC preparation. The DLC can be deposited on a surface to protect an electronic equipment and its accessories.

### BACKGROUND

A Diamond-like Carbon (DLC) film is a metastable material with sp3 and sp2 carbon bonds, which has excellent characteristics of both diamond and graphite, such as high hardness, high resistivity, good optical property and excellent abrasion resistance. The diamond-like carbon film has many different structural forms. For example, carbon nano materials with special structures (fullerene-like carbon, nano amorphous carbon and graphene) have attracted extensive attention in scientific and industrial fields as a kind of high-performance solid lubricating materials because of their ultra-low friction coefficient, high hardness, good elastic recovery and excellent wear resistance.

One of existing preparation methods for the diamond-like carbon film is physical vapor deposition, including forming a coating by magnetron sputtering to obtain the DLC film, and the other is chemical vapor deposition, including a Plasma Enhanced Chemical Vapor Deposition (PECVD) for depositing the DLC film, which applies hydrocarbon gases such as methane, ethane, acetylene, benzene and butane as carbon source. Under the action of plasma, the hydrocarbon gases undergo complex processes such as activation, ionization and deposition to prepare the DLC film containing certain hydrogen.

Further, the DLC preparation method involves complex reaction process, and the characteristics of the DLC film are affected by many factors, such as a composition proportion of raw materials and the control of specific process conditions. As such, characteristics of the DLC film are significantly affected by the control of the same raw material process conditions, and the influence is relatively complex. For different coating products, different performance of the DLC film may be required. In the field of electronic equipment, such as a screen of a smart phone, a surface rigidity needs to be improved, while a good light transmission performance is required without affecting a visual effect of a screen of the electronic equipment.

### SUMMARY

An advantage of the present disclosure is to provide a DLC preparation apparatus and a preparation method, which utilizes a synergistic action of a radio frequency electric field and a high-voltage pulse electric field disposed internally and externally to perform a plasma enhanced chemical deposition (PECVD) reaction, so as to form a DLC film.

Another advantage of the present disclosure is to provide a DLC preparation apparatus and a preparation method, which utilizes a synergistic action of an inductive coupling radio frequency electric field and a high-voltage pulse electric field to provide reaction conditions of the plasma enhanced chemical deposition reaction, so as to prepare the DLC film by a reaction gas under the reaction conditions.

Another advantage of the present disclosure is to provide a DLC preparation apparatus and a preparation method, which utilizes the synergistic action of the radio frequency electric field and the high-voltage pulse electric field in different directions to perform the plasma enhanced chemical deposition reaction, so as to form the DLC film.

Another advantage of the present disclosure is to provide a DLC preparation apparatus and a preparation method, which utilizes a low-power radio frequency discharge to maintain a plasma environment and inhibit an arc discharge in a high-voltage discharge process, so as to improve a chemical deposition efficiency.

Another advantage of the present disclosure is to provide a DLC preparation apparatus and a preparation method, which controls a performance of the DLC film, maintains a high deposition efficiency, and obtains a DLC film with high surface hardness and high transmittance by controlling a bias value.

Another advantage of the present disclosure is to provide a DLC preparation apparatus and a preparation method, which changes an ion concentration and increases a coating efficiency by controlling a radio frequency power.

Another advantage of the present disclosure is to provide a DLC preparation apparatus and a preparation method, which adjusts a glow phenomenon by controlling a chamber pressure, so as to adjust a film-forming rate and a film quality.

Another advantage of the present disclosure is to provide a DLC preparation apparatus and a preparation method, which can obtain a target DLC by controlling discharge characteristics of radio frequency and high voltage pulse, a flow of the reaction gas, a coating time and other process parameters.

Another advantage of the present disclosure is to provide a DLC preparation apparatus and a preparation method, wherein in some embodiments, a direction of the radio frequency electric field is perpendicular to a direction of the high-voltage pulse electric field.

Another advantage of the present disclosure is to provide a DLC preparation apparatus and a preparation method, wherein the DLC film can deposit on a surface of an electronic equipment and its accessories to maintains a good light transmittance.

Another advantage of the present disclosure is to provide a DLC preparation apparatus and a preparation method, wherein the PECVD process has short reaction time and high deposition efficiency, which makes overall production efficiency high and is suitable for large-scale production and application.

An embodiment of the preset disclosure provides a DLC preparation apparatus, including: a main body having a reaction chamber for accommodating a substrate; a plasma source device; and at least one gas supply device for providing a reaction gas to the reaction chamber, wherein the plasma source device is disposed outside the main body to provide a radio frequency electric field to the reaction chamber to promote a generation of plasma, so that the reaction gas can be deposited on a surface of the substrate by a PECVD process to form a diamond-like carbon (DLC) film.

According to some embodiments of the present disclosure, the DLC preparation apparatus further includes a radio frequency power supply, wherein the radio frequency power supply is electrically coupled with the plasma source device to provide power for the plasma source device.

According to some embodiments of the present disclosure, the plasma source device includes a gas inlet frame, an isolation plate and an induction coil, the gas inlet frame is sealingly disposed outside the main body, and the isolation plate is disposed between the gas inlet frame and the induction coil.

According to some embodiments of the present disclosure, the gas inlet frame comprises a communicating channel for communicating the reaction chamber of the main body with the gas supply device.

According to some embodiments of the present disclosure, the gas inlet frame includes at least one communicating hole and a main channel, the main body includes a window communicated with the reaction chamber, and the window of the main body is communicated with the communicating hole and the main channel of the gas inlet frame to form the communicating channel.

According to some embodiments of the present disclosure, the communicating hole and the main channel are disposed perpendicular to each other.

According to some embodiments of the present disclosure, the gas inlet frame includes at least one communicating hole, an inner communicating channel, a gas distribution hole and a main channel, the at least one communicating hole is communicated with the outside for inputting gases, the gas distribution hole is disposed in an inner side of the gas inlet frame and communicated with the main channel, the inner communicating channel is communicated with the communicating hole and the gas distribution hole, and an window of the main body, the communicating hole of the gas inlet frame, the inner communicating channel, the gas distribution hole and the main channel are communicated to form the communicating channel.

According to some embodiments of the present disclosure, a plurality of inner communicating channels are communicated to form an inner ring channel.

According to some embodiments of the present disclosure, the plasma source device further includes an outer cover plate, and the induction coil is clamped between the isolation plate and the outer cover plate.

According to some embodiments of the present disclosure, the gas inlet frame includes a main frame body and a plug-in assembly, the main frame body is sealingly disposed outside the main body, the plug-in assembly is disposed outside the main frame body, and the isolation plate, the induction coil and the outer cover plate are inserted into the plug-in assembly.

According to some embodiments of the present disclosure, the isolation plate is a ceramic sealing plate.

According to some embodiments of the present disclosure, the plasma source device includes a radio frequency inductively coupled plasma source for providing an inductive coupling electric field.

According to some embodiments of the present disclosure, the DLC preparation apparatus includes a placement electrode plate and a pulse power supply, the placement electrode plate is accommodated in the reaction chamber, the placement electrode plate is electrically coupled with the pulse power supply for providing a pulse electric field to the reaction chamber, and the substrate is disposed on the placement electrode plate.

According to some embodiments of the present disclosure, placement electrode plate is provided with a gas hole for communicating both sides of the placement electrode plate.

According to some embodiments of the present disclosure, a plurality of placement electrode plates are disposed parallel to and spaced apart from each other.

According to some embodiments of the present disclosure, a voltage of the pulse power supply ranges from - 200V to - 5000v.

According to some embodiments of the present disclosure, the gas supply device includes a plasma source supply device for providing a plasma source gas to the reaction chamber to activate a PECVD reaction.

According to some embodiments of the present disclosure, the plasma source gas includes one or more selected from a group consisting of inert gas, nitrogen and fluorocarbon gas.

According to some embodiments of the present disclosure, the gas supply device includes a reaction gas raw material supply part, and the reaction gas raw material supply device is configured to provide a hydrocarbon gas (CxHy) to the reaction chamber, so that the hydrocarbon gas (CxHy) can be deposited on the surface of the substrate by the PECVD process to form the diamond-like carbon film.

According to some embodiments of the present disclosure, the gas supply device includes an auxiliary gas supply device, and the auxiliary gas supply device provides an auxiliary gas to the reaction chamber to adjust a C-H content in the diamond-like carbon film, and to react with the hydrocarbon gas (CxHy) to deposit on the surface of the substrate to form the diamond-like carbon film.

According to some embodiments of the present disclosure, the auxiliary gas includes one or more selected from a group consisting of nitrogen, hydrogen and fluorocarbon gas.

According to some embodiments of the present disclosure, the DLC preparation apparatus further includes a temperature detection device, and the temperature detection device is disposed at an equivalent position of the substrate.

Another embodiment of the present disclosure provides a DLC film preparation method, including: providing a reaction gas to a reaction chamber, and promoting the reaction gas to deposit on a surface of a substrate in the reaction chamber by a PECVD process to form a diamond-like carbon (DLC) film under an action of a radio frequency electric field and a pulse electric field.

According to some embodiments of the present disclosure, the radio frequency electric field is turned on before the pulse electric field is turned on.

According to some embodiments of the present disclosure, the radio frequency electric field is disposed outside the pulse electric field.

According to some embodiments of the present disclosure, the radio frequency electric field is an inductive coupling electric field.

According to some embodiments of the present disclosure, the DLC film preparation method further includes: providing a plasma source gas to the reaction chamber to activate a PECVD reaction, wherein the radio frequency electric field and the pulse electric field act on the plasma source gas at the same time.

According to some embodiments of the present disclosure, the DLC film preparation method further includes: providing an auxiliary gas to the reaction chamber to adjust a C-H content in the diamond-like carbon film, and to react with a hydrocarbon gas (CxHy) to deposit on the surface of the substrate to form the DLC film.

According to some embodiments of the present disclosure, a placement electrode plate is disposed in the reaction chamber, and the placement electrode plate is electrically coupled with a pulse power supply to provide the pulse electric field to the reaction chamber.

According to some embodiments of the present disclosure, the DLC film preparation method further includes: detecting a temperature at an equivalent position of the substrate for a feedback control.

Another embodiment of the present disclosure provides a DLC film preparation method, including: (a) providing a plasma source gas into a reaction chamber loaded with a substrate; (b) turning on a pulse power supply and a radio frequency power supply to provide a radio frequency electric field and a pulse electric field respectively so as to activate the plasma source gas to generate plasma; and (c) providing a hydrocarbon gas (CxHy) to the reaction chamber to deposit a diamond-like carbon (DLC) film on a surface of the substrate.

According to some embodiments of the present disclosure, in step (b), the radio frequency electric field is turned on before the pulse electric field is turned on.

According to some embodiments of the present disclosure, the radio frequency electric field is disposed outside the pulse electric field.

According to some embodiments of the present disclosure, the radio frequency electric field is an inductive coupling electric field.

According to some embodiments of the present disclosure, step (c) includes: providing an auxiliary gas to the reaction chamber to adjust a C-H content in the diamond-like carbon film, and to react with the hydrocarbon gas (CxHy) to deposit on the surface of the substrate to form the DLC film.

According to some embodiments of the present disclosure, the DLC film preparation method further includes: pumping gases in the reaction chamber to adjust a gas pressure in the reaction chamber.

According to some embodiments of the present disclosure, the DLC film preparation method further includes: detecting a temperature at an equivalent position of the substrate for a feedback control.

### BRIEF DESCRIPTION OF THE DRAWINGS

FIG. 1 is a block diagram of a DLC preparation method according to an embodiment of the present disclosure.
FIG. 2 is a block diagram of a DLC preparation apparatus according to an embodiment of the present disclosure.
FIG. 3 is a schematic diagram of a DLC preparation apparatus according to an embodiment of the present disclosure.
FIGS. 4A-4B are perspective views of a DLC preparation apparatus according to an embodiment of the present disclosure.
FIG. 4C is a perspective view of a DLC preparation apparatus according to another embodiment of the present disclosure.
FIG. 5A is a perspective view of a DLC preparation apparatus according to another embodiment of the present disclosure.
FIG. 5B is a schematic view of a gas inlet frame of a DLC preparation apparatus according to an embodiment of the present disclosure.
FIG. 6 is a schematic view of a DLC preparation apparatus according to an embodiment of the present disclosure.
FIG. 7 is a transmission electron microscope view of a diamond-like carbon film according to an embodiment of the present disclosure.

### DETAILED DESCRIPTION

The following description is used to disclose the present disclosure in order to enable one skilled in the art to practice the disclosure. Preferred embodiments in the following description are given by way of example only, and other obvious variations will occur to those skilled in the art. The basic principles of the present disclosure defined in the following description can be applied to other embodiments, variations, modifications, equivalents, and other technical schemes without departing from the scope of the present disclosure.

It should be appreciated by those skilled in the art that, in the context of the present disclosure, terms "longitudinal", "lateral", "upper", "lower", "front", "back", "left", "right", "vertical", "horizontal", "top", "bottom", "inner", "outer" are based on orientation or positional relationships illustrated in the figures, which are merely for convenience in describing and simplifying the present disclosure, and do not indicate or imply that devices or components must have a particular orientation and be constructed and operated in a particular orientation, thus the above terms should not be construed as limiting the present disclosure.

It should be understood that the term "a" or "an" should be interpreted as "at least one" or "one or more", that is, in some embodiments, the number of one component may be one, and in other embodiments, the number of the component may be multiple, thus the term "a" and "an" should not be construed as limiting the number.

References to "one embodiment", "embodiment", "example embodiment", "various embodiments" or "some embodiments" indicate that an embodiment of the present disclosure may include specific features, structures or characteristics, but not every embodiment must include the features, structures or characteristics. In addition, some embodiments may have some, all or none of the features described for other embodiments.

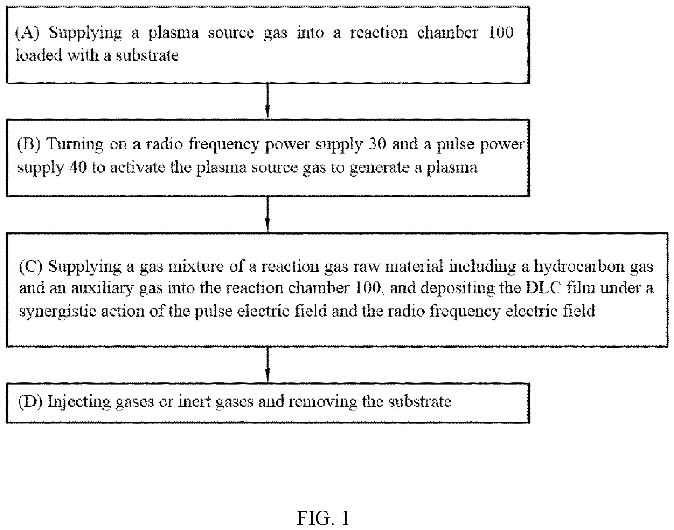

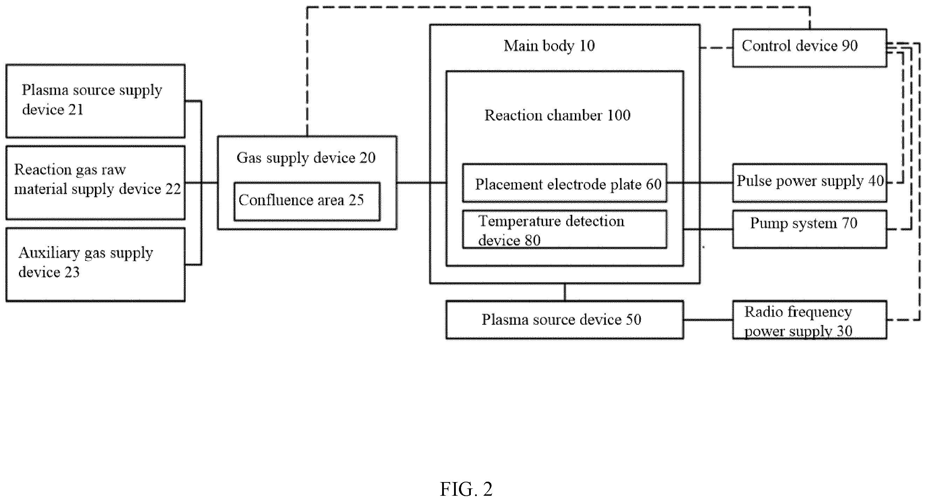

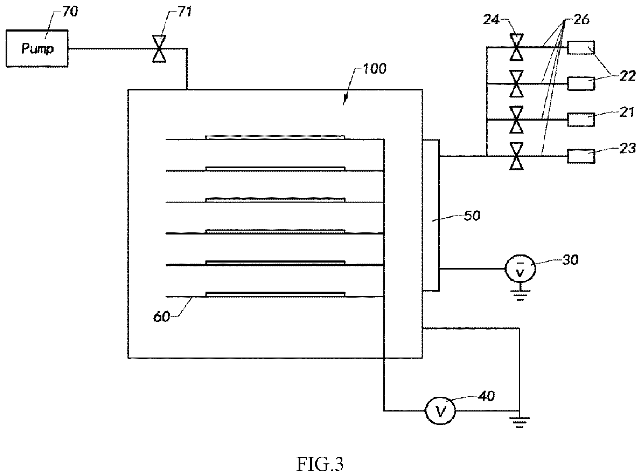

FIG. 1 is a block diagram of a DLC preparation method according to an embodiment of the present disclosure. FIG. 2 is a block diagram of a DLC preparation apparatus according to above embodiment of the present disclosure. FIG. 3 is a schematic diagram of a DLC preparation apparatus according to above embodiment of the present disclosure.

Referring to FIG. 1 to FIG. 5A, the present disclosure provides a DLC preparation apparatus, which is applied for a PECVD reaction to prepare a DLC film. The DLC film can deposit on a surface of a substrate to improve surface properties of the substrate. Further, the DLC preparation apparatus can perform chemical deposition on the surface of the substrate by a plasma enhanced chemical deposition (PECVD) process to form the DLC film. In other words, the substrate is placed in a reaction chamber of the DLC preparation apparatus for the plasma enhanced chemical vapor deposition process to form the DLC film on the surface of the substrate.

"Substrate" means an object having a small or large area to be coated or having a surface improved by the method of the present disclosure. The substrate referred to herein may be made of glass, plastic, inorganic material or any other material having a surface to be coated or improved. The substrate can be an electronic device and its accessories, for example, but is not limited to smart phones, tablet computers, e-readers, wearable devices, televisions, computer display screens, glass screens and flexible screens.

"Plasma" refers to a hybrid state of electrons, positive and negative ions, excited atoms, molecules and free radicals.

Further, according to an embodiment of the present disclosure, the DLC preparation apparatus uses a hydrocarbon gas (CxHy) as a reaction gas raw material to perform the plasma enhanced chemical vapor deposition process to obtain the DLC film.

The DLC film can improve a surface rigidity of the substrate, such as Mohs hardness, and can improve shatter resistance and wear resistance of the substrate. The DLC film is a nano film having a small thickness, for example, ranging from 10 to 2000Nm.

The DLC preparation apparatus can vapor deposits CxHy gas reaction raw material on the surface of the substrate through the PECVD process. With the plasma chemical deposition reaction process, the thickness of the DLC film can be small, such as nano size, and the target DLC film can be obtained by controlling process parameters during the PECVD process, for example, the DLC film with a predetermined thickness. That is, the DLC film with the predetermined thickness is obtained under different predetermined reaction conditions, rather than selecting any value.

In CxHy, x is an integer from 1 to 10 and y is an integer from 1 to 20. The reaction gas raw material can be a single gas or a mixture of two or more gases. Preferably, the hydrocarbon gas is selected from methane, ethane, propane, butane, ethylene, acetylene, propylene and propyne in gaseous state under normal pressure, and can also be vapor formed by decompression or heating evaporation, such as benzene vapor and toluene vapor.

The plasma enhanced chemical vapor deposition (PECVD) process has many advantages over other existing deposition processes: (1) Dry deposition does not need to use organic solvents; (2) An etching effect of the plasma on the surface of the substrate makes a deposited film have good adhesion with the substrate; (3) The film can be deposited evenly on the surface of an irregular substrate with strong vapor permeability; (4) The coating has good designability, and compared with a micron control accuracy of a liquid phase method, the chemical vapor phase method can control a thickness of the coating in nano scale; (5) The coating has simple structure, the chemical vapor method uses plasma activation, and does not need to design a specific initiator to initiate composite coatings of different materials, and a variety of raw materials can be combined through adjusting input energy; (6) Good compactness can be achieved, and the chemical vapor deposition method often activates multiple active sites in a process of plasma initiation, which is similar to the condition in which a molecule has multiple functional groups in solution reaction, and a cross-linked structure is formed between molecular chains through multiple functional groups; (7) As a coating treatment technology, it has excellent universality and wide selection range of coating objects and raw materials used for coating.

The plasma enhanced chemical vapor deposition (PECVD) process generates plasma through glow discharge, and the discharge methods include microwave discharge, radio frequency discharge, ultraviolet, electric spark discharge, etc.

Further, according to some embodiments of the present disclosure, when preparing the DLC film by the DLC preparation apparatus, a plasma source gas is supplied into the DLC preparation apparatus for activating the chemical deposition reaction of the reaction gas raw material. The plasma source gas includes, but is not limited to, inert gas, nitrogen and fluorocarbon gas, the inert gas includes, but is not limited to, HE and Ar, and the fluorocarbon gas includes, but is not limited to carbon tetrafluoride. The plasma source gas can be a single gas or a mixture of two or more gases. The plasma source gas can be supplied with the reaction gas raw material simultaneously or successively. Certainly, the plasma source gas is supplied first, and then the reaction gas raw material is supplied. Certainly, in some embodiments of the present disclosure, the plasma source gas may be omitted, that is, the reaction gas raw material directly deposits on the substrate surface. At this time, the amount of the reaction gas raw material required increases and the reaction speed will be affected to a certain extent.

Further, according to some embodiments of the present disclosure, when preparing the DLC film by the DLC preparation apparatus, an auxiliary gas is supplied into the DLC preparation apparatus, and the auxiliary gas cooperates with the reaction gas raw material to form the DLC film, that is, as an integral part of the diamond-like carbon film. The auxiliary gas includes a non-hydrocarbon gas, that is, a gas other than CxHy, containing elements other than C and H. The auxiliary gas is used to adjust the performance of the DLC film, such as adjusting the rigidity and improving the flexibility. By adding the auxiliary gas, the content of C-C and/or the content of C-H and other bonds in the DLC film formed by simple hydrocarbon gas can be adjusted, and the performance of the DLC film can be adjusted in combination with the characteristics of the auxiliary gas itself.

For example, the auxiliary gas includes, but is not limited to, nitrogen, hydrogen and fluorocarbon gas, and the auxiliary gas can be supplied with the reaction gas raw material simultaneously or successively. Optionally, the auxiliary gas can be supplied simultaneously with the reaction gas raw material. In other words, hydrogen-containing diamond-like carbon films, nitrogen-containing diamond-like carbon films and fluorine-containing diamond-like carbon films with different hydrogen content can be prepared. The auxiliary gas can adjust the proportional content of C-H bond, C-N bond and N-H bond in the DLC film so as to change the performance of the DLC film.

It should be noted that the addition of the auxiliary gas can adjust the performance of the DLC film, which can relatively weaken the rigidity and original performance of the DLC film while increasing and improving the performance, thus it is necessary to balance the addition amount. It has been found that when the auxiliary gas is added, the predetermined performance of the DLC film can be improved, but when the amount of the auxiliary gas is increased to a certain extent, the hardness of the DLC film will decrease significantly. For example, when the auxiliary gas is hydrogen, the auxiliary gas can adjust a proportion of carbon and hydrogen in the DLC film, such as increasing the content of C-H bond and improving the flexibility of the DLC film. It should be noted that when a hydrogen content is greater than a predetermined range, the auxiliary gas will destroy the rigidity of the DLC film, so it is necessary to control the added content. When the hydrogen content is greater than 40%, its rigidity will decrease significantly. The DLC film with a higher hydrogen content has higher lubricity and transparency than the DLC film with a lower hydrogen content. A certain amount of hydrogen is conducive to the formation of SP3 bond and can improve the hardness to a certain extent. However, with the further increase of the hydrogen content, the hardness of the DLC film will gradually decrease.

It should be noted that the addition of the auxiliary gas can not only adjust the performance of the DLC film, but also can increase the ionization concentration in the PECVD reaction process and promote the reaction to proceed more quickly.

According to some embodiments of the present disclosure, when preparing the DLC film by the DLC preparation apparatus, the cooperation action of the radio frequency electric field and the pulse electric field can assist in completing the plasma enhanced chemical vapor deposition process. Optionally, both the radio frequency and the high voltage pulse act on the PECVD deposition process at the same time. Under the cooperation action of the radio frequency and high-voltage pulse, a low-power radio frequency discharge is used to maintain the plasma environment and inhibit the arc discharge in the process of high-voltage discharge, so as to improve the efficiency of chemical deposition.

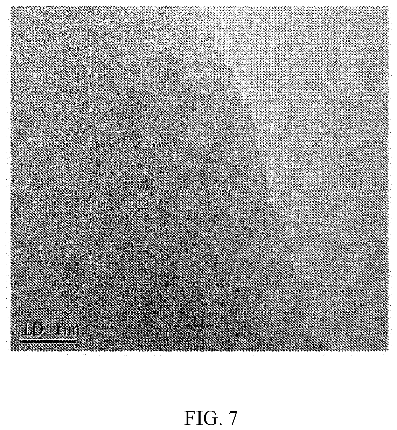

Radio frequency can make the whole coating process in plasma environment by discharging the inert gas and the reaction gas raw material, and the reaction gas raw material is in high-energy state. The pulse high voltage allows the pulse power supply to generate a strong electric field in the discharge process, and active particles in the high-energy state are accelerated to deposit on the surface of the substrate under the action of the strong electric field to form an amorphous carbon network structure. When the pulse electric field is in a non-discharge state, it is conducive to the free relaxation of the amorphous carbon network structure of the DLC film deposited on the surface of the substrate. Under the action of thermodynamics, the carbon structure changes to a stable phase - curved graphene lamellar structure, and is buried in the amorphous carbon network to form a transparent graphene like structure. In other words, the cooperation of the radio frequency electric field and changing pulse electric field enables the DLC film to be deposited on the surface of the substrate quickly and stably. Referring to FIG. 7, a transmission electron microscope view of a diamond-like carbon film according to the above embodiment of the present disclosure is shown The DLC film is composed of amorphous and nanocrystalline structures.

Further, when preparing the DLC film by the DLC preparation apparatus, the plasma source gas, the reaction gas raw material and the auxiliary gas are added to the DLC preparation apparatus in stages, and accordingly, the radio frequency electric field and the pulse electric field are selectively applied to the reaction gas raw material in stages.

For example, in some embodiments, when the plasma source gas is added to the DLC preparation apparatus, that is, in a first stage, the radio frequency electric field and the pulse electric field are applied. In this stage, the plasma source gas forms part of the plasma under the action of the radio frequency electric field and the pulse electric field, and further promotes the generation of part of the plasma through the interaction between gas molecules, such as mutual impact. When turning on the radio frequency electric field and the pulse electric field, the radio frequency electric field is turned on before the pulse electric field is turned on. In this way, a glow start can be achieved easily, so as to make the ionization better. When the reaction gas raw material and the auxiliary gas raw material are added, that is, in a second stage, the radio frequency electric field and the pulse electric field are applied at the same time, in other words, the radio frequency power supply and the pulse power supply are kept turned on. In this stage, a part of the reaction gas raw material generates a plasma under the action of the radio frequency electric field and the pulse electric field, a part of the reaction gas generates a plasma under the excitation of the plasma generated by the plasma source gas, and a part of the auxiliary gas generates a plasma under the action of the radio frequency electric field and the pulse electric field, and a part of the auxiliary gas is excited by the action of other plasmas to generate a plasma, so that the plasma concentration in the DLC preparation apparatus increases continuously, so as to activate the deposition reaction process of the plasma, so that the DLC film can be deposited on the surface of the substrate quickly and effectively. It can be understood by those skilled in the art that the plasma enhanced chemical vapor deposition process is a very complex reaction process, and the reactions in the ionization deposition process are not limited to above contents.

When the plasma source gas is added to the DLC preparation apparatus, that is, in a first stage, only the pulse electric field is applied. In this stage, the plasma source gas forms at least a part of the plasma under the action of the pulse electric field, and the interaction between gas molecules, such as mutual impact, further promotes the generation of the plasma. When the reaction gas raw material and the auxiliary gas raw material are added, that is, in a second stage, the radio frequency electric field and the pulse electric field are applied at the same time. In this stage, a part of the reaction gas raw material generates a plasma under the action of the radio frequency electric field and the pulse electric field, a part of the reaction gas generates a plasma under the excitation of the plasma generated by the plasma source gas, and a part of the auxiliary gas generates a plasma under the action of the radio frequency electric field and the pulse electric field, and a part of the auxiliary gas is excited to generate a plasma under the action of other plasma, so that the plasma concentration in the DLC preparation apparatus increases continuously, so as to activate the deposition reaction process of plasma, so that the DLC film can be deposited on the surface of the substrate quickly and effectively.

In some embodiments, the radio frequency power supply and the high-voltage pulse power supply can be applied simultaneously or successively. In some embodiments, when the plasma source gas is added, the high-voltage pulse power supply is applied first, and when the reaction gas raw material is added, the radio frequency power supply is applied again, so that the two electric fields work together successively. In some embodiments, the radio frequency power supply is applied when the plasma source gas is added, and the high-voltage pulse power supply is applied when the reaction gas raw material is added, so that the two electric fields work together successively.

It should be noted that the selection of the radio frequency electric field and the pulse electric field can affect the performance of the DLC film formed by deposition, and there are different preferred modes for different device structures. In the device structure with the radio frequency electric field and the pulse electric field arranged inside and outside of the present disclosure, the effect of forming the film by applying the pulse electric field and the radio frequency electric field simultaneously in the first stage and the second stage is better than applying the pulse electric field or the radio frequency electric field alone. In the sequence of turning on, turning on the radio electric field before turning on the pulse electric field is better than turning on the radio frequency electric field and the pulse electric field at the same time and turning on the pulse electric field before turning on the radio frequency electric field. Turning on the radio frequency electric field before turning on the pulse electric field makes it easier for the glow start of the gas so as to generate plasma. It should be noted that in some embodiments, the plasma source gas added in the first stage only generates a part of the plasma, but due to its basic properties, such as inert gas, it will not be deposited on the surface of the substrate, or it does not constitute a component of the diamond-like carbon film. When the plasma source forms the plasma, the plasma acts on the surface of the substrate and etches the surface of the substrate, that is, removing the residue on the surface of the substrate and preparing the basis for the deposition of the reaction gas raw material. The surface etching effect of the plasma source on the surface of the substrate makes the DLC film more firmly deposited on the surface of the substrate. In some embodiments, the plasma source gas added in the first stage only generates a part of the plasma, which will not only etch the substrate, but also deposit on the surface of the substrate, such as the deposition reaction with the reaction feed gas in the second stage. For example, nitrogen and fluorocarbon gas, which conduct deposition reaction together with the reaction gas raw material hydrocarbon gas in the second stage, can adjust the proportional content of C-H bond, C-N bond and N-H bond in the DLC film, so as to change the performance of the DLC film.

In the second stage, the reaction source gas and the auxiliary gas are jointly vapor deposited on the surface of the substrate to form the DLC film.

It should be noted that the synergistic action of the radio frequency and the high-voltage pulse enhances the deposition efficiency, so that the protective film can be effectively deposited on the surface of the substrate, that is, the DLC film can be formed by the chemical deposition reaction in a short time, which improves the production efficiency and enables the DLC film to be produced in batch industry.

Further, when preparing the DLC film by the DLC preparation apparatus, a gas flow into the apparatus is controlled to control the deposition rate and deposition thickness of the DLC film. For example, the gas flow of the plasma source gas, the reaction gas raw material and the auxiliary gas is controlled. When preparing the DLC film by the DLC preparation apparatus, a pressure, a radio frequency power, a pulse voltage, a duty cycle, a coating time and other process parameters in the reaction chamber may be controlled, so as to obtain the expected DLC film. That is, by adjusting and controlling the process parameters such as the gas flow, the pressure in the reaction chamber, the radio frequency power, the pulse voltage, the duty cycle and the coating time, the performance of the obtained DLC film can be controlled, including thickness, hardness, transparency, etc.

Further, when preparing the DLC film by the DLC preparation apparatus, a reaction temperature in the preparation apparatus can be controlled. For example, a temperature around the substrate can be detected by the temperature detection module, and is fed back to adjust other process parameters so that the temperature is controlled within a predetermined range. The temperature range in the preparation apparatus is 25 °C - 100 °C. Optionally, the temperature range is 25 °C - 50 °C.

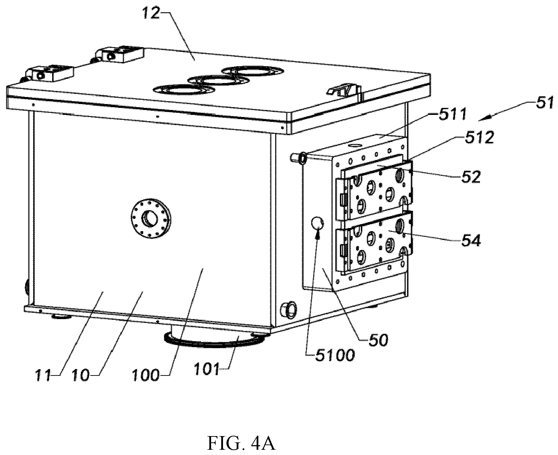

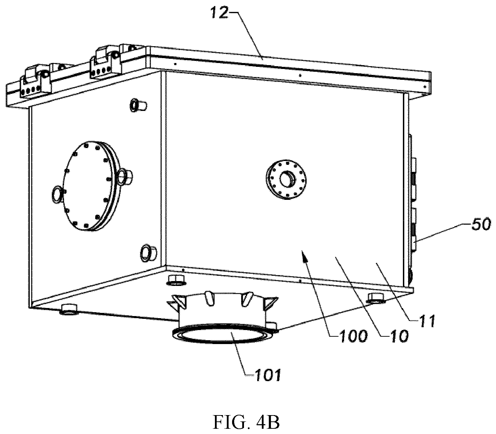

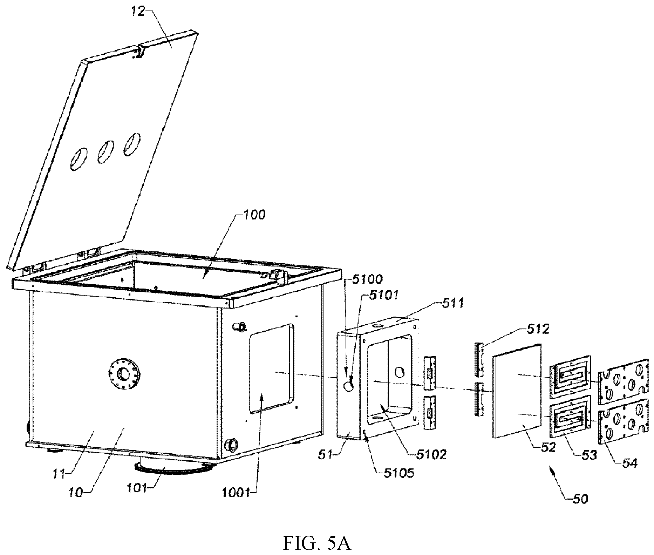

FIG. 2 is a block diagram of a DLC preparation apparatus according to an embodiment of the present disclosure. FIG. 3 is a schematic diagram of the DLC preparation apparatus according to the above embodiment of the present disclosure. FIGS. 4A-4B are perspective views of an embodiment of the DLC preparation apparatus according to the above embodiment of the present disclosure. FIG. 5A is an exploded schematic diagram of an embodiment of the DLC preparation apparatus according to the above embodiment of the present disclosure.

Referring to FIG. 2 and FIG. 3, the present disclosure provides a DLC preparation apparatus for preparing the DLC film. Further, the DLC apparatus is used for feeding reaction gas for a PEDVD deposition to form the DLC film on the surface of the substrate.

The DLC preparation apparatus includes a main body 10 and a reaction chamber 100. The reaction chamber 100 can accommodate the substrate and the incoming gas for deposition reaction. The main body 100 forms the reaction chamber 100.

Optionally, the reaction chamber 100 is a closed chamber, that is, the reaction chamber 100 will not allow gas flow in an uncontrolled state.

Further, a plurality of gas supply devices 20 include a plasma source supply device 21, a reaction gas raw material supply device 22 and an auxiliary gas supply device 23. The plasma source supply device 21 is controllably communicated with the reaction chamber 100, and the plasma source supply device 21 is configured to supply the plasma source gas to the reaction chamber 100. The plasma source gas includes, but is not limited to, inert gas, nitrogen and fluorocarbon gas, the inert gas includes but is not limited to He and Ar, and the fluorocarbon gas includes but is not limited to carbon tetrafluoride. The plasma source gas can be a single gas or a mixture of two or more gases.

The reaction gas raw material supply device 22 is controllably communicated with the reaction chamber 100, and the reaction gas raw material supply device 22 is configured to supply the reaction gas raw material to the reaction chamber 100. The reaction gas raw material is a hydrocarbon gas (CxHy), where x is an integer of 1-10 and y is an integer of 1-20. The reaction gas raw material may be a single gas or a mixture of two or more gases. Optionally, the hydrocarbon gas may be selected form a group consisting of methane, ethane, propane, butane, ethylene, acetylene, propylene and propyne in gaseous state under normal pressure, and may also be vapor formed by decompression or heating evaporation, such as benzene vapor and toluene vapor.

The auxiliary gas supply device 23 is controllably communicated with the reaction chamber 100, and the auxiliary gas supply device 23 is configured to supply the auxiliary gas to the reaction chamber 100. The auxiliary gas includes, but is not limited to, hydrogen, nitrogen and fluorocarbon gases.

According to some embodiments of the present disclosure, the plasma source supply device 21 includes a plurality of supply pipelines 26 for supplying different plasma source gases. More specifically, the number of supply pipelines 26 or the number of connections of the plasma source supply device 21 is determined by the plasma source gas to be supplied. That is, when the gas type of the plasma source to be supplied is 1, the number of the supply pipelines 26 of the plasma source supply device 21 is 1; when the gas type of the plasma source to be supplied is 2, the number of the supply pipelines 26 of the plasma source supply device 21 is 2, and so on. Optionally, each supply pipeline 26 of the plasma source supply device 21 supplies a single gas, that is, one supply pipeline 26 only allows one gas to pass through, rather than multiple gases or mixed gases. In this way, a pre-reaction between gases can be prevented and the amount of the supplied gas can be easily controlled. Alternatively, in some embodiments, multiple gases may be supplied into the pipeline, or the same gas may be supplied into multiple pipelines.

In some embodiments of the present disclosure, the plurality of supply pipelines 26 of the plasma source supply device 21 include a supply pipeline 26 for introducing the plasma source gas into the reaction chamber. For example, in some embodiments, the supply pipeline 26 of the plasma source supply device 21 is used to supply argon.

The reaction gas raw material supply device 22 includes a plurality of supply pipelines 26 for supplying different reaction gas raw materials. More specifically, the number of supply pipelines 26 or the number of connections of the reaction gas raw material supply device 22 is determined by the reaction gas raw material to be supplied. That is, when the gas type of the reaction gas raw material to be supplied is 1, the number of the supply pipelines 26 of the reaction gas raw material supply device 22 is 1; when the gas type of the reaction gas raw material to be supplied is 2, the number of the supply pipelines 26 of the reaction gas raw material supply device 22 is 2, and so on. Optionally, each supply pipeline 26 of the reaction gas raw material supply device 22 supplies a single gas, that is, one supply pipeline 26 only allows one gas to pass through, rather than multiple gases or mixed gases. In this way, a pre-reaction between gases can be prevented and the amount of the supplied gas can be easily controlled. Alternatively, in some embodiments, multiple gases may be supplied into the pipeline, or the same gas may be supplied into multiple pipelines.

In some embodiments of the present disclosure, the reaction gas raw material supply device 22 includes two supply pipelines 26 for feeding two different gases respectively. For example, one pipeline is used to supply methane and the other pipeline is used to supply acetylene.

The auxiliary gas supply device 23 includes a plurality of supply pipelines 26 for supplying different auxiliary gases. More specifically, the number of the supply pipelines 26 or the number of connections of the auxiliary gas supply device 23 is determined by the auxiliary gas to be supplied. That is, when the gas type of the auxiliary gas to be supplied is 1, the number of the supply pipelines 26 of the auxiliary gas supply device 23 is 1; when the gas type of the auxiliary gas to be supplied is 2, the number of the supply pipelines 26 of the auxiliary gas supply device 23 is 2, and so on. Optionally, each supply pipeline 26 of the auxiliary gas supply device 23 supplies a single gas, that is, one supply pipeline 26 only allows one gas to pass through, rather than multiple gases or mixed gases. In this way, a pre-reaction between gases can be prevented and the amount of the supplied gas can be easily controlled. Alternatively, in some embodiments, multiple gases may be supplied into the pipeline, or the same gas may be supplied into multiple pipelines.

In some embodiments of the present disclosure, the auxiliary gas supply device 23 includes a supply pipeline 26 for supplying the auxiliary gas into the reaction chamber. For example, in some embodiments, the supply pipeline 26 of the auxiliary gas supply device 23 is used to supply hydrogen.

According to some embodiments of the present disclosure, the diamond-like carbon film preparation apparatus includes a confluence area 25, the confluence area 25 is communicated with the reaction chamber 100, and a confluence of the gases of the gas supply devices 20 is formed in the confluence area 25. That is, the confluence area is communicated with the plasma source supply device 21, the reaction gas raw material supply device 22 and the auxiliary gas supply device 23. In some embodiments of the present disclosure, the incoming gas is fed into the reaction chamber 100 after the confluence through the confluence area. Certainly, in other embodiments of the present disclosure, each supply device can also independently supply gas into the reaction chamber 100.

The gas supply device 20 includes a control valve 24 for controlling the on-off of the gas. Further, the gas supply device 20 includes a plurality of control valves 24, which are respectively disposed in the supply pipelines 26 of the plasma source supply device 21, the reaction gas raw material supply device 22 and the auxiliary gas raw material supply device to control the gas flow in each pipeline respectively.

The diamond-like carbon film preparation apparatus includes a radio frequency power supply 30 and a pulse power supply 40. The radio frequency power supply 30 is configured to provide a radio frequency electric field to the reaction chamber 100, and the pulse power supply 40 is configured to provide a pulse electric field to the reaction chamber 100.

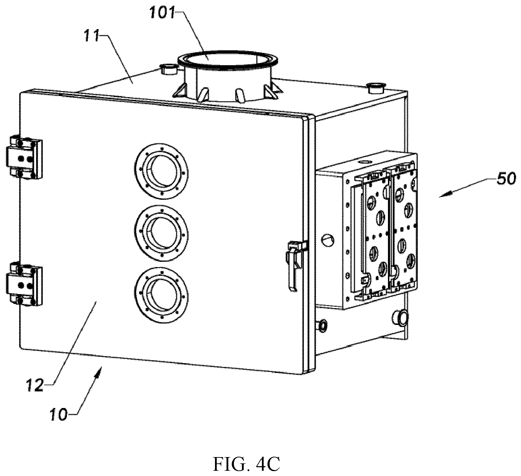

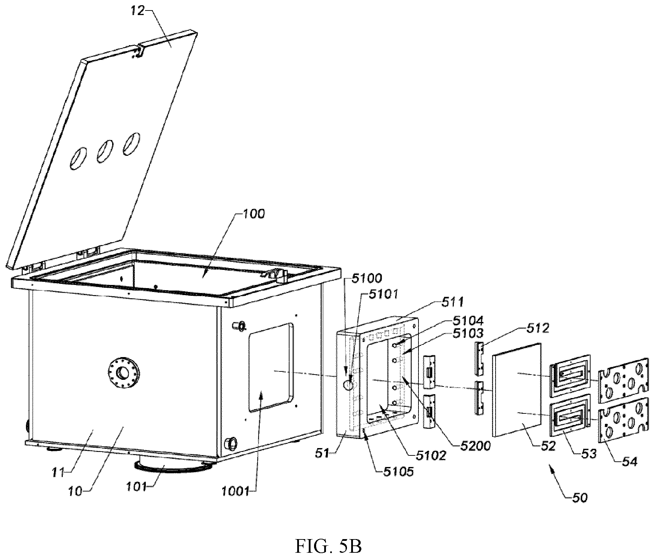

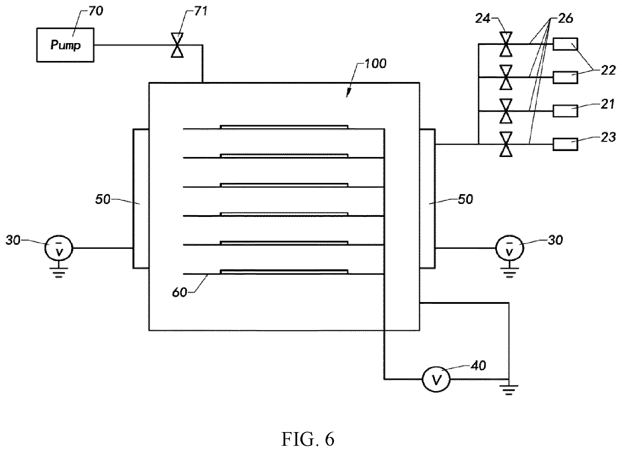

FIGS. 4A-4B are perspective views of an embodiment of the DLC preparation apparatus according to the above embodiment of the present disclosure. FIG. 4C is a perspective view of another embodiment of the DLC preparation apparatus according to the above embodiment of the present disclosure. FIG. 5A is an exploded schematic diagram of an embodiment of the DLC preparation apparatus according to the above embodiment of the present disclosure. FIG. 5B is a modified embodiment of a gas inlet frame. FIG. 6 is a schematic diagram of a modified embodiment of the DLC preparation apparatus according to the above embodiment of the present disclosure.

The DLC preparation apparatus includes a plasma source device 50. The plasma source device 50 is electrically coupled with the radio frequency power supply 30 to obtain an electric energy from the radio frequency power supply 30 and generate the radio frequency electric field.

The plasma source device 50 is arranged outside the main body 10. For example, the plasma source device 50 is arranged on at least one side of the main body 10. For example, when the main body 10 has a square structure, the plasma source device can be arranged on one or more of six sides of the main body 10. When the main body 10 has a cylindrical structure, the plasma source device can be arranged on an annular side and/or two bottom surfaces of the main body 10.

Referring to FIGS. 4A-5A, in some embodiments of the present disclosure, the main body 10 further includes a box 11 and a control door 12, and the control door 12 can control the opening or closing of the box 11. The main body 10 is provided with a gas extraction port 101 arranged on one side of the box 11. In some embodiments of the present disclosure, the gas extraction port 101 is arranged on a back side of the box 11, that is, an side opposite to the control door 12.

In another embodiment of the present disclosure, referring to FIG. 4C, the gas extraction port 101 is arranged on a top side of the box 11, that is, a top side adjacent to the control door 12. When installed and used, the control door 12 can be opened towards an outside direction, that is, an operator side. The plasma source device 50 is arranged on an adjacent side, and the gas extraction port 101 is arranged on an upper side, that is, a top side of the DLC preparation apparatus.

Optionally, the plasma source device 50 is a Radio Frequency Inductively Coupled Plasma (RF-ICP) source for providing an inductive coupling electric field to the reaction chamber 100 to generate a plasma.

The plasma source device 50 includes a gas inlet frame 51, an isolation plate 52 and an induction coil 53. The gas inlet frame 51 is sealingly connected to the main body 10. More specifically, the gas inlet frame 51 is attached to one side of the main body 10. The isolation plate 52 is arranged between the gas inlet frame 51 and the induction coil 53.

Referring to FIG. 5a, the gas inlet frame 51 includes at least one communicating channel 5100 for communicating the main body and the gas supply device, so as to supply the gas raw material into the reaction chamber of the main body through the gas supply device. The main body 10 includes a window 1001 communicated with the reaction chamber 100 and the outside. The communicating channel 5100 is communicated with the window 1001. That is, during operation, the gas supply device 20 supplies gas, the gas enters the gas inlet frame 51, and enters the reaction chamber 100 through the communicating channel 5100 of the gas inlet frame 51 and the window 1001.

Further, the gas inlet frame 51 includes at least one communicating hole 5101 and a main channel 5102, and the communicating hole 5101 is communicated with the main channel 5102 to form one communicating channel 5100. More specifically, the communicating hole 5101 is arranged in a transverse direction of the gas inlet frame 51, that is, a plane where the communicating hole 5101 is located is generally parallel to an outer side of the main body 10. The main channel 5102 is arranged in a longitudinal direction of the gas inlet frame 51, that is, the direction of the main channel 5102 is perpendicular to the outer side of the main body 10. In other words, the direction of the gas entering the gas inlet frame 51 is different from the direction of the gas entering the reaction chamber 100. More specifically, the direction of the gas entering the gas inlet frame 51 and the direction of the gas entering the reaction chamber 100 are perpendicular to each other.

It should be noted that the gas supply unit 20 needs to be connected to the gas inlet frame 51 through a pipeline, and the isolation plate 52 and the induction coil 53 are directly installed on the outside of the gas inlet frame 51, that is, the gas inlet frame 51 provides an installation position for the isolation plate 52 and the induction coil 53, and the incoming gas forms a plasma under the action of the inductive coupling electric field generated by the induction coil 53. Thus, the channel into which the gas enters, that is, the communicating hole 5101, is arranged in the transverse direction, while the main channel 5102, the channel into which the gas enters the reaction chamber 100, is arranged in the longitudinal direction, so as to make more efficient use of an external space of the main body 10, so that a main volume of the DLC preparation apparatus will not be too large, and the occupation of the placement space is reduced.

A size of the main channel 5102 is larger than a diameter of the communicating hole 5101, or a capacity of the main channel 5102 is larger than a capacity of the communicating hole 5101. It should be noted that the communicating hole 5101 is a channel for gas to enter, and a flow rate of the gas can be more accurately controlled through the channel having a smaller size. The gas inlet channel is a channel for forming plasma under the action of the induction coil 53. A larger space makes the action area of the inductive electric field larger and the interaction between more gas molecules or ions stronger.

Further, the communicating hole 5101 can have an extending straight-line shape, a curve shape or other irregular shape, that is, an interior of the communicating hole 5101 can extend linearly along a side of the gas inlet frame 51, or can curvedly run through the side of the gas inlet frame 51. The number of the communicating hole 5101 may be one or more. In some embodiments of the present disclosure, one communicating hole 5101 is respectively arranged on each of four sides of the gas inlet frame 51 to be communicated with the main channel 5102 respectively, so that side spaces of the gas inlet frame 51 can be used.

The gas inlet frame 51 includes a plurality of mounting holes 5105 for installing the gas inlet frame on the main body 10 through a fixing element. For example, the gas inlet frame is installed on the main body 10 through a screw passing through the mounting holes 5105.

Referring to FIG. 5B, another modified embodiment of the gas inlet frame 51 according to the present disclosure is shown. In this embodiment, the gas inlet frame 51 further includes an inner communicating channel 5103 arranged inside the gas inlet frame 51 and connects two adjacent communicating holes 5101 inside. The inner side of the gas inlet frame 51 is provided with at least one inner gas distribution hole 5104 for communicating the inner communicating channel 5103 and the main channel 5102. That is, in this embodiment of the present disclosure, the communicating hole 5101 is not directly communicated with the main channel 5102, but is communicated with the main channel 5102 through the inner communicating channel 5103 and the inner gas distribution hole 5104. Optionally, a plurality of inner gas distribution holes 5104 are respectively arranged at different positions on the inner side of the gas inlet frame 51, for example, four inner sides of the gas inlet frame 51, so that the gas can enter the main channel 5102 more evenly.

In some embodiments of the present disclosure, the gas inlet frame 51 includes a plurality of inner communicating channels 5103, which are connected with each other to form an inner annular channel 5200, so that the gas can be supplied through any one of the communicating holes 5101, and the gas can be supplied to the main channel 5102 through any one of the inner gas distribution holes 5104 on the other side.

Further, different gases can be combined in advance in the inner communicating channel 5103 or the formed inner annular channel 5200, so that the gases can be mixed more sufficiently, and a preliminary reaction can be carried out to form more plasmas.

Further, the number of the inner gas distribution holes 5104 may be greater than the number of the communicating holes 5101, so that the gas can enter the main channel 5102 more quickly or with more gas volume so as to form more plasma in the main channel, and enter the reaction chamber 100.

In some embodiment of the present disclosure, the gas inlet frame 51 can have one communicating hole 5101 for gas inlet, that is, when a variety of gases need to be transported, the gases can be first converged and then enter through the communicating hole 5101, or the gases can successively enter the inner communicating channel 5103 through the same communicating hole 5101, and then disperse to various positions of the main channel 5102 through the inner distribution hole 5104.

The isolation plate 52 blocks one port of the main channel 5102 and isolates the main channel 5102 of the gas inlet frame 51 and the induction coil 53, that is, the gas enters through the communicating hole 5101 and enters the reaction chamber 100 through the main channel 5102 without flowing to one side of the induction coil 53. Further, the isolation plate 52 seals and isolates the gas but does not isolate the electric field, that is, the gas in the main channel 5102 or the gas in the reaction chamber 100 can be affected by the inductive electric field of the induction coil 53. Optionally, the isolation plate 52 is a ceramic sealing plate, so as to reduce the influence of the inductive electric field of the induction coil 53 fed into the main channel 5102 and the reaction chamber 100.

The plasma source device 50 further includes an outer cover plate 54 arranged on the outside of the induction coil 53. In other words, the induction coil 53 is clamped between the isolation plate 52 and the outer cover plate 54.

The gas inlet frame 51 includes a main frame 511 and a plug-in assembly 512. The main frame 511 is sealingly arranged on the outside of the main body 10, the plug-in assembly 512 is arranged on the outside of the main frame 511, and the isolation plate 52, the induction coil 53 and the outer cover plate 54 are successively inserted into the plug-in assembly 512, so that the isolation plate 52, the induction coil 53 and the outer cover plate 54 are detachably fixed to the main frame 511.

The DLC preparation apparatus includes a placement electrode plate 60. The placement electrode plate 60 is electrically coupled with the pulse power supply 40 to obtain electric energy from the pulse power supply 40 so as to generate a pulse electric field. The placement electrode plate 60 is arranged in the reaction chamber 100 to provide a pulse electric field to the reaction chamber 100. The placement electrode plate has a planar plate structure suitable for placing the substrate. That is, a sample to be deposited is placed on the placement electrode plate 60 for deposition. It should be noted that, on the one hand, the placement electrode plate 60 is used to place the substrate, on the other hand, the placement electrode plate 60 is used to provide a pulse electric field, that is, the pulse electric field is applied at a placement position of the substrate, so that the pulse electric field is applied from the bottom and around the substrate, which is more direct.

According to some embodiments of the present disclosure, the diamond-like carbon film preparation apparatus utilizes the synergistic action of the radio frequency electric field and the high-voltage pulse electric field to assist in completing the plasma enhanced chemical vapor deposition process. Optionally, both the radio frequency and the high voltage pulse act on the PECVD deposition process at the same time. In the synergistic action of the radio frequency and the high-voltage pulse, a low-power radio frequency discharge is used to maintain the plasma environment and inhibit the arc discharge in the process of high-voltage discharge, so as to improve the efficiency of chemical deposition. The arc discharge is a further strengthened discharge form of glow discharge, and an instantaneous current can reach tens or even hundreds of amps. These high currents pass through a surface of product and may damage the product, which is more harmful to electronic products, while the low-frequency radio frequency discharge maintains a low-temperature plasma environment, so as to inhibit the arc discharge in the process of pulse high-voltage discharge. The radio frequency electric field and the pulse electric field cooperate with each other to optimize the deposition process, so as to reduce the damage of the substrate to be deposited.

The plasma source device 50 can discharge the plasma source gas and the reaction gas raw material to make the whole coating process in the plasma environment and the reaction gas raw material in a high-energy state. The pulse power supply 40 generates a strong electric field during the discharge process, and the active particles in the high-energy state are accelerated to be deposited on the surface of the substrate under the action of the strong electric field to form an amorphous carbon network structure. When the pulse power supply 40 and the placement electrode plate 60 are in the non-discharge state, it is conducive to the free relaxation of the amorphous carbon network structure of the DLC film deposited on the surface of the substrate. Under the action of thermodynamics, the carbon structure changes to a stable phase - curved graphene lamellar structure, and is buried in the amorphous carbon network to form a transparent graphene like structure. In other words, the combination of the radio frequency electric field and changing pulse electric field enables the DLC film to be deposited on the surface of the substrate quickly and stably.

It should be noted that the synergistic action of the radio frequency electric field and the high-voltage pulse electric field enhances the deposition efficiency, so that the protective film can be effectively deposited on a screen surface of an electronic equipment, that is, the DLC film can be formed by the chemical deposition reaction in a short time, which improves the production efficiency and enables the DLC film to be produced in batch industry.

It should be noted that in the prior art, the diamond-like carbon (DLC) film is usually formed by a magnetron sputtering coating. The magnetron sputtering process is a kind of PVD process, which uses a block graphite target as carbon source, has a low ionization efficiency and deposition efficiency, and thus is limited in some applications. In some embodiments of the present disclosure, the PECVD carbon source is a gas, which is ionized by the external direct current pulse power supply 40 and the radio frequency power supply 30, thus the ionization degree and deposition efficiency are improved, and the DLC film with high hardness can be formed with lower cost. On the other hand, in the PVD process, graphite is used as the carbon source target. In the preparation process, it needs to be heated in advance, and the reaction rate is slow. Therefore, there is more heat accumulation and higher reaction temperature in the whole process. In the PECVD reaction process of the present disclosure, the carbon source is a gas, which does not need the heating process. Moreover, the deposited film is thin and the deposition time is short, thus the heat accumulation in the whole process is less and the reaction temperature is low, and the reaction temperature can be controlled at 25 °C ~ 100°C, which is suitable for the coating of some electronic equipment.

It should be noted that in the actual industrial production, the production efficiency is one of the important factors. Taking a screen of a mobile phone as an example, which is only one of many components of the mobile phone, it is not feasible to take a lot of time to only improve some performance of the screen in practical production and application. For example, in some existing DLC films, although the performance can be improved through a long reaction time, it is not suitable for batch production application, which is also one of the factors limiting the practical application of some films. In some embodiments of the present disclosure, the PECVD chemical deposition is carried out in the reaction chamber 100 through the DLC preparation apparatus. Through the synergistic action of the radio frequency and the high-voltage pulse, the deposition rate can be effectively improved by a relatively simple process, thus the diamond-like carbon films can be widely used in batch industrial production.

According to some embodiments of the present disclosure, the placement electrode plate 60 has a gas hole for communicating both sides of the placement electrode plate 60. The gas hole is used to discharge the gas entering the reaction chamber 100 through the gas hole. Further, when the gas flowing into the confluence area enters the reaction chamber 100 along the gas inlet channel of the inductively coupled plasma source (ICP), a discharge effect is generated on the gas around the placement electrode plate 60, causing the gas to be ionized to produce plasmas.

Further, the placement electrode plate 60 includes a plurality of gas holes arranged in an array on the placement electrode plate 60, so that the gas flow can evenly enter and reach a space above the placement electrode plate 60 located below, and thus a relatively consistent electric field effect can act on the gas flow.

The gas hole can be a straight through hole, or can be a hole which communicates both sides of the placement electrode plate 60 in a curve or broken line. The cross-sectional shape of the gas hole can be circular, square, polygonal or other curved shapes.

The plurality of placement electrode plates 60 are arranged at intervals in parallel to each other. A spacing between two adjacent placement electrode plates 60 is a predetermined distance. The selection of the distance between the two adjacent placement electrode plates 60, on the one hand, needs to consider the electric field conditions applied by the substrate on the two adjacent placement electrode plates 60, on the other hand, needs to consider the space utilization, that is, the number of samples that can be deposited at one time. For example, if the distance is too large, the effect of the pulse electric field is poor, which affects the ionization efficiency and deposition efficiency, and the space utilization rate is low, if the distance is too small, the effect of the pulse electric field is too strong, which will affect the performance of the substrate, such as electronic equipment, and is not conducive to the taking and placing of the samples, thus the working efficiency is low. Therefore, the influence of different factors needs to be balanced. For example, the spacing between two adjacent placement electrode plates 60 is 10-200mm. Optionally, the spacing between two adjacent placement electrode plates 60 is 20mm-150mm. Optionally, the spacing between two adjacent placement electrode plates 60 is 20mm-30mm, 30mm-40mm, 40mm-50mm, 50mm-60mm, 60mm-70mm, 70mm-80mm, 80mm-90mm, 90mm-100mm, 100mm-110mm, 110mm-120mm, 120mm-130mm, 130mm-140mm or 140mm-150mm.

The setting position and number of the plasma source device 50 outside the main body 10 can be adjusted as needed. In some embodiment of the present disclosure, the number of the plasma source device 50 is 1, which is arranged on one side of the main body 10. Further, the plasma source device 50 is arranged on one side of the main body 10 perpendicular to the placement electrode plates 60, refer to FIG. 3. In another embodiment of the present disclosure, referring to FIG. 6, two plasma source devices 50 are respectively symmetrically arranged on two sides of the main body 10. Further, two plasma source devices 50 are respectively arranged on two sides perpendicular to the placement electrode plates 60 of the main body 10.

Referring to FIG. 3, the DLC preparation apparatus includes a pump system 70. The pump system 70 is connected to the reaction chamber 100 to adjust the gas pressure in the reaction chamber 100. The pump system 70 includes a pressure regulating valve 71 for regulating the pressure in the reaction chamber 100. The pump system 70 can be used to extract the gas in the reaction chamber 100 to reduce the pressure to a predetermined pressure range. The pump system 70 can be used to supply the gas to the reaction chamber 100 to provide the gas reaction raw materials.

The DLC preparation apparatus includes a temperature detection device 80. The temperature detection device 80 is used to detect the temperature in the reaction chamber 100 for feedback control of other process parameters of the diamond-like carbon film preparation apparatus. For example, the temperature detection device 80 is a thermocouple.

Optionally, the temperature detection device 80 is arranged at an equivalent position of a placement position of the substrate to facilitate the detection of the real-time reaction temperature of the substrate. For example, the temperature detection device 80 is arranged directly below a sample placement position of the placement electrode plate 60, or the temperature detection device 80 is arranged around the sample placement position of the placement electrode plate 60, or the temperature detection device 80 is arranged directly above the sample placement position of the placement electrode plate 60, or the temperature detection device 80 is arranged at the sample placement position of the placement electrode plate 60, for example, in the gas holes below the substrate.

The reaction temperature control range in the reaction chamber 100 of the DLC preparation apparatus is 25 °C - 100 °C. Optionally, the temperature range is 25°C -50 °C. The above temperature range has little influence on the substrate and is suitable for products that are not resistant to high temperature, such as electronic products.

It should be noted that the materials used in mainstream electronic products are polymer materials, which have poor heat-resistant deformation ability. Generally, the temperature resistance is below 100 °C. As a final process of manufacturing process, the coating treatment needs to change the performance of raw materials, so the low-temperature process is a hard demand of processing electronic products. When preparing the diamond-like carbon film, the reaction temperature is detected in real time through the thermocouple arranged at the equivalent position of the product, and the reaction temperature is controlled so as not to affect the electronic equipment. When forming the diamond-like carbon film, it can be formed on a separate part of the product, such as an unassembled electronic screen, or on an assembled product, such as a screen assembled into an electronic device, and the process conditions are more flexible.

The DLC preparation apparatus includes a control device 90. The control device 90 can control the reaction conditions in the preparation apparatus. For example, the control device 90 controls the gas supply of the plasma source supply device, the gas supply of the reaction gas raw material, the gas supply of the auxiliary gas, the operation of the pump system 70, and the operation of the temperature detection device 80, the pulse power supply 40 and the radio frequency power supply 30. The control device 90 can obtain the target diamond-like carbon film by controlling the discharge characteristics of the radio frequency and the high-voltage pulse, the flow rate of the reaction gas, the coating time and other process parameters.

Further, the control device 90 can control the electrode discharge characteristics of the pulse power supply 40 and the radio frequency power supply 30, and can control the gas flow, the coating time and other process parameters of each gas supply device 20, so as to conveniently obtain the target DLC film.

It should be noted that the preparation process of ion exchange reinforced glass in the prior art is cumbersome. It is necessary to heat potassium nitrate plasma salt at high temperature to form an ion bath, and the ion exchange time is long and the cost is high. In the embodiments of the present disclosure, the DLC preparation apparatus directly deposits diamond-like carbon film on the surface of glass and other substrates by the PECVD process, which can be completed at a room temperature, the required time is short, and the cost can be controlled. On the other hand, the DLC preparation apparatus in the embodiments of the present disclosure adopts the radio frequency and the high-voltage pulse to assist the plasma chemical vapor deposition, uses the low-power radio frequency discharge to maintain the plasma environment and suppress the arc discharge in the high-voltage discharge process. Compared with the physical vapor deposition processes such as magnetron sputtering in the prior art, the temperature of the substrate in the whole deposition process is low, and thus the process can be applied to the coating of some electronic devices that are not resistant to high temperature. When strengthening the glass screen of the mobile phone, the glass of the mobile phone can be assembled first, and then DLC vapor deposition coating can be carried out, that is, the DLC film can be coated after the manufacturing of the electronic equipment, thus the process flexibility is high. On the other hand, the control device 90 controls the synergistic action of multiple parameters, and the preparation process has good controllability.

Referring to FIG. 1, according to some embodiments of the present disclosure, a method for preparing a DLC film is provided, which includes the following steps:
(A) Supplying a plasma source gas into a reaction chamber 100 loaded with a substrate;
(B) Turning on a radio frequency power supply 30 and a pulse power supply 40 to activate the plasma source gas to generate a plasma;
(C) Supplying a gas mixture of a reaction gas raw material including a hydrocarbon gas and an auxiliary gas into the reaction chamber 100, and depositing the DLC film under a synergistic action of the pulse electric field and the radio frequency electric field; and
(D) Injecting gases or inert gases and removing the substrate.

Specifically, the preparation method of the DLC film may include the following steps:
Step (1): Sample surface cleaning and activation: placing the substrate after ultrasonic treatment in alcohol and acetone in a sample chamber and reducing the vacuum degree to below 1.5 × 10⁻³pa, and supplying a high-purity helium matrix in the plasma source gas for etching and cleaning the substrate. Turning on the radio frequency power supply 30 and the high-voltage pulse power supply 40, and generating the plasma by the plasma source gas glow discharge to etch, clean and activate the substrate for 10 minutes. That is, an embodiment of step (A) - step (B).
Step (2): Deposition of the DLC film: after cleaning, preparing the transparent hard hydrogen containing diamond-like carbon film by the radio frequency and high-voltage pulse assisted plasma chemical vapor deposition, supplying the hydrocarbon gas source as the reaction gas source, turning on the radio frequency power supply 30 and the high-voltage pulse power supply 40, or keep the power supply on in S1 for deposition, and turning off the power supply after depositing the film, releasing the vacuum and taking out the sample. That is, an embodiment of step (C) - step (D).

It should be noted that the diamond-like carbon film preparation apparatus includes multi-layer electrode groups, so multiple or more substrates can be placed at one time and large-area coating requirements can be met, so as to carry out batch coating process.

In step (1), in the sample surface cleaning and activating stage, the flow of argon is 50sccm-200sccm, the pressure of the reaction chamber 100 is below 30mtorr, the voltage of the high-voltage pulse power supply 40 is -1000V, the duty cycle is 10%, and the cleaning time is 10mins.

In step (1) of some embodiment, the surface of the substrate needs to be pretreated by the action of the radio frequency electric field and the high-voltage pulse electric field, that is, in the process of step (B), only the pulse power supply 40 is turned on so that the electrode plate 60 can discharge. For example, in step (1), the plasma source gas, such as argon or helium, generates a plasma under the action of the high-voltage pulse electric field and the radio frequency electric field, and the plasma vapor deposition is performed on the surface of the substrate so as to perform micro etching on the surface of the substrate, that is, stripping a small amount of surface layer, but due to an inert effect, the gas cannot be deposited on the surface of the substrate. In other words, in this process, a part of the surface is removed without forming a deposition layer. Step (1) prepares ionization conditions for the deposition of the reaction gas raw material, and make the surface of the substrate be slightly etched so as to clean the surface, so that the subsequently deposited diamond-like carbon film can be more firmly bonded to the surface of the substrate.

It should be noted that the gas flow added to the reaction chamber 100 corresponds to the corresponding pressure. Too high or too low pressure will affect the ionization effect. Too low pressure cannot achieve the cleaning effect, and too high pressure will have the risk of damaging the substrate. The length of cleaning time affects the cleaning effect, too short cleaning time cannot achieve the cleaning effect, and too long cleaning time will have the risk of excessive etching in the process, and will increase the whole process cycle and increase the process cost. According to some embodiments of the present disclosure, in the stage of supplying the plasma source, the flow of argon or helium is 50sccm-200sccm, the pressure in the reaction chamber is 50-150mtorr, the voltage of the high-voltage pulse power supply 40 is - 200V to - 5000v, the duty cycle is 10% - 60%, and the cleaning time is 5 - 15mins. In these ranges, the above factors can be well adjusted to facilitate the whole deposition process of the DLC film.

In step (2), the transparent hard hydrogen containing diamond-like carbon film is prepared by the radio frequency and high voltage pulse voltage assisted plasma chemical vapor deposition. This method can maintain the plasma environment of the whole coating stage through the radio frequency. Through the pulse high voltage applied to the substrate of the sample, active particles can be deposited on the surface of the substrate under the action of the strong electric field during the discharge of the pulse power supply 40 to form an amorphous carbon network structure. The non-discharge process is the process of free relaxation of the amorphous carbon network structure. The carbon structure changes to the stable phase-nano crystalline graphene lamellar structure under the action of thermodynamics, and is buried in the amorphous carbon network to form a transparent amorphous/nano crystalline graphene lamellar composite structure. For example, 99.999% of methane, argon, hydrogen and 99.5% of acetylene are used as film-forming gas (the carbon source is provided by methane or acetylene and can be doped with argon or hydrogen, and the ratio of the carbon source and doped gas can be adjusted from 5:1 to 1:5). 30-500 SCCM reaction gas is supplied by the gas supply device 20, and the chamber pressure is set to 0.5 -10 PA. In addition, 100 -700 W power is applied to the inductively coupled plasma source (ICP) 50 to generate an inductive oscillating electromagnetic field in the reaction chamber 100 to ionize the passing gas to form a plasma. A bias voltage of - 600 to - 1200 V is applied to the cathode electrode plate to accelerate the traction of the plasma formed by the inductively coupled plasma source (ICP), so as to form a transparent hard nanocomposite film on the substrate.

The parameters of the coating stage of the diamond-like carbon film containing hydrogen are set as follows: the gas flow of CH₄ is 40-100sccm, the gas flow of C₂H₂ is 50-200sccm, the gas flow of Ar is 40-100sccm, the gas flow of H₂ is 40-100sccm, the pressure in the reaction chamber 100 is 50-150mtorr, the power of the radio frequency power supply 30 is 50-300w, the voltage of the bias pulse power supply 40 is - 200V to - 5000v, the duty cycle is 10% - 80%, the coating time is 5-30mins. Finally, a 5-1000 nm transparent hard diamond-like carbon film containing hydrogen is obtained.

In the deposition stage of the reaction gas raw material, different gas flow ratios affect the atomic ratio of the DLC film and the performance of the film. According to some embodiments of the present disclosure, when the gas flow of CH₄ is 40-100sccm, the gas flow of C₂H₂ is 50-200sccm, the gas flow of Ar is 40-100sccm and the gas flow of H₂ is 40-100sccm, the rigidity of the DLC film is good, the flexibility of the DLC film can be adjusted by hydrogen, and the predetermined deposition rate is maintained.

In the deposition stage of the reaction gas raw material, the power electric field of the radio frequency power supply 30 and the power supply voltage of the pulse electric field affect the temperature rise, ionization rate, deposition rate and other relevant parameters of the ionization process. According to some embodiments of the present disclosure, when the power range of the radio frequency power supply 30 is 50-300w, the voltage of the bias pulse power supply 40 is - 200v to -5000v, and the duty cycle is 10% - 80%, the temperature rise cannot be too fast, and the process time cannot be excessively increased, thereby obtaining a high ionization rate and maintaining a good deposition rate.

The magnitude of negative bias voltage is directly related to the ionization of gas and the migration ability when reaching the surface of the product. High voltage means higher energy and high hardness coating can be obtained. However, it should be noted that high ion energy will have a strong bombardment effect on the substrate of the product, so bombardment pits will be generated on the surface at the micro scale. At the same time, high energy bombardment will accelerate the temperature rise, which may lead to excessive temperature and damage the product. Therefore, it is necessary to balance the bias value, reaction temperature and reaction rate.

In some embodiments, the frequency of the radio frequency is 20 - 300kHz, and the higher pulse frequency can avoid the continuous accumulation of charge on the surface of insulating products, suppress the phenomenon of large arc and increase the limit of coating deposition thickness.

In the deposition stage of the reaction gas raw material, if the coating time is too short, the formed film layer is thin and the hardness performance is poor, if the coating time is too long, the thickness increases, but the transparency is affected. According to some embodiments of the present disclosure, when the coating time is 5-30mins, it can balance the thickness, hardness and transparency, and finally obtain a transparent hard hydrogen containing diamond-like carbon film of 5-1000nm.

Further, in step (2), the temperature range in the reaction chamber 100 is 25 °C - 100 °C. Optionally, the temperature range is 25 °C ~ 50 °C.

The present disclosure is further explained below in combination with the embodiments, but the content of the present disclosure is not limited to the following embodiments.

The main performance indexes of the product are shown in Table 1 below.

**Table 1**

| Test items | Performance index | Test method |
|---|---|---|
| Film appearance | Dense and smooth | Visual inspection |
| Film thickness (nm) | 20-100nm | Filmetrics F20 Film thickness tester |
| Transmittance | 90-92% | Transmittance meter |
| Surface roughness Sa (nm) | 1-6.5 | Three dimensional profilometer |
| Film nano hardness (GPa) | 15-25GPa | Nanoindentation instrument |
| Elastic recovery coefficient | 75-85% | Nanoindentation instrument |
| Mohs hardness | 7-8H | Mohs hardness tester |
| Scratch test | No scratch marks | Mohs hardness 7H Scratch pen |
| Wear resistance test | More than 50000 times | Alcohol abrasion tester ( test condition: 1000g, #0000 Steel velvet, 10mm ^{∗} 10mm) |

### Example

In the following, among various coating conditions as the embodiment of the present disclosure, the film forming of DLC coating is carried out. Taking the film forming under the specified conditions described in the above embodiment as an example and the film forming under conditions other than these conditions as a comparative example, the film characteristics of DLC coating in each case are measured respectively. It should be noted that in the example and the comparative example, the device with the composition described in the above embodiment with reference to FIG. 1 is used as the film-forming apparatus. In addition, 6.5-inch quartz glass screen is selected as the substrate. As a prerequisite, the glass screen needs to be ultrasonically cleaned with absolute ethanol and acetone for 20 minutes, then dried with nitrogen, clamped in the vacuum chamber, the gas pressure in the chamber is below 1.5×10⁻³Pa through the pump system, 100sccm high-purity argon is injected, the bias power supply (DC pulse) and the radio frequency power supply are turned on, the chamber pressure is controlled at 25mtorr, the voltage of the bias power supply is 500-900v, the duty cycle is 10% and the frequency is 80kHz, and the substrate is cleaned for 10 minutes. Then, the film is coated on the substrate. As shown in the example and the comparative example described below, the DLC coating is carried out by ICP (inductively coupled plasma) enhanced CVD (chemical vapor deposition).

### First group of examples: combination of methane and argon

First, for examples 1-3 and comparative examples 1-2, the coating gas is a combination of CH4 with a purity of 99.999% and AR. The coating conditions (gas pressure, gas flow, power supply condition and coating time) of examples 1-3 and comparative examples 1-2 are shown in Table 2 below. In addition, table 2 also records characteristics of the film under different coating conditions (film thickness, hardness and light transmittance).

**Table 2**

| | | | Example 1 | Example 2 | Example 3 | Comparative example 1 | Comparative example 2 |
|---|---|---|---|---|---|---|---|
| Coating condition | Gas | | CH₄+Ar | CH₄+Ar | CH₄+Ar | CH₄+Ar | CH₄+Ar |
| | Gas pressure (mTorr) | | 25 | 25 | 25 | 25 | 25 |
| | Gas flow (SCCM) | CH₄ | 100 | 100 | 100 | 100 | 100 |
| | | Ar | 100 | 100 | 100 | 100 | 100 |
| | High voltage pulse power | Voltage (V) | 500 | 900 | 1200 | - | 900 |
| | | duty cycle (%) | 10 | 10 | 10 | - | 10 |
| | supply | Frequency (KHz) | 80 | 80 | 80 | - | 80 |
| | Radio frequency power supply | Power (W) | 300 | 300 | 300 | 300 | - |
| | Coating time (min) | | 2 | 2 | 2 | 15 | 2 |
| Film characteristics | Film thickness (nm) | | 21 | 29 | 20 | 35 | 18 |
| | Hardness (Mohs hardness) | | 6-7 | 7 | 6-7 | 3 | 6-7 |
| | Transmittance (%) | | 92 | 93 | 92 | 89 | 91 |
| | Wear resistance times | | 80000 | 85000 | 70000 | 1000 | 40000 |

The chamber pressure of this series of embodiments is maintained at 25mtorr, and different bias voltage values are set to carry out the examples in the embodiments. As a comparative example, the bias power supply and the radio frequency power supply are selected to be used separately.

It can be seen from the data in the table that by using the coating apparatus of the present disclosure, the film layer with excellent performance can be obtained by using different bias voltage values, and the film-forming speed is also suitable for industrial production, but too low bias voltage value will lead to insufficient energy obtained by the plasma, while too high bias voltage value has sputtering effect on the substrate, resulting in low deposition efficiency and increase of internal stress. From example 2, it can be concluded that appropriate process parameters can obtain high surface hardness (Mohs hardness 7H) and high transmittance, which is very suitable for application on flexible screen.

Comparing example 2 with comparative examples 1 and 2, it can be found that the film-forming speed of the film deposited only by ICP without applying the bias voltage is slow and the hardness performance is poor, while the performance and quality indexes of the film obtained only by the bias voltage without ICP technology are worse than those in example 1. As shown in FIG. 7, the composite structure of carbon and amorphous graphene can be obtained by a comprehensive utilization of the ICP and bias electrode technology.

### The second group of Examples: combination of acetylene and argon

First, for examples 4 to 6 and comparative examples 3 and 4, the reaction gas is a combination of C₂H₂ with a purity of 99.9% and Ar with a purity of 99.999%. The coating conditions (gas pressure, gas flow, power supply conditions and coating time) of examples 4 to 6 and comparative examples 3 and 4 are shown in table 3 below. In addition, table 3 also records the characteristics of the film under different coating conditions (film thickness, hardness and light transmittance).

**Table 3**

| | | | Example 4 | Example 5 | Example 6 | Comparative example 3 | Comparative example 4 |
|---|---|---|---|---|---|---|---|
| **Coating condition** | Gas | | C₂H₂+ Ar | C₂H₂+ Ar | C₂H₂+ Ar | C₂H₂+Ar | C₂H₂+Ar |
| | Gas pressure (mTorr) | | 25 | 25 | 25 | 25 | 25 |
| | Gas flow (SCCM) | C₂H₂ | 100 | 100 | 100 | 100 | 100 |
| | | Ar | 100 | 100 | 100 | 100 | 100 |
| | High voltage pulse power supply | Voltage (V) | 900 | 900 | 900 | - | 900 |
| | | duty cycle (%) | 10 | 10 | 10 | - | 10 |
| | | Frequency (KHz) | 80 | 80 | 80 | - | 80 |
| | Radio frequency power supply | Power (W) | 50 | 300 | 600 | 600 | - |
| | Coating time (min) | | 1 | 1 | 1 | 15 | 1 |
| Film characteristic s | Film thickness (nm) | | 22 | 32 | 45 | 53 | 30 |
| | Hardness (Mohs hardness) | | 6-7 | 7 | 6-7 | 3 | 6-7 |
| | Transmittance (%) | | 92 | 93 | 91 | 86 | 91 |
| | Wear resistance times | | 70000 | 80000 | 75000 | 1000 | 45000 |

The chamber pressure of this series of embodiments is maintained at 25mtorr, and the voltage of the bias power supply is set to 900v. Different radio frequency is set to carry out the experiment in the embodiments. As a comparative example, the bias power supply and the radio frequency power supply are selected to be used separately. By comparing the comparative examples 1 and 2, the effects of different power supply combinations on the film quality under different carbon sources are compared.

It can be seen from the data in the table that by using the coating apparatus of the present disclosure, the film with excellent performance can be obtained by reasonably setting the parameters. Increasing the radio frequency power can improve the ion concentration, so as to increase the coating efficiency, but too fast deposition efficiency will affect the quality of the film. It can be seen from example 5 that the coating with high light transmittance and high hardness can be obtained by appropriate process parameters.

Comparing example 5 and comparative examples 1 to 4, it can be found that the film-forming speed and hardness performance of the film deposited only by ICP without applying the bias voltage are slow, while the performance and quality indexes of each film obtained by the bias voltage without ICP technology are worse than those of each example, and the phenomenon remains the same under different gas combinations.

### Third group of examples: a combination of acetylene and hydrogen

First, for examples 7 to 9 and comparative examples 5 and 6, the reaction gas is a combination of C₂H₂ with a purity of 99.999% and H₂. The coating conditions (gas pressure, gas flow, power supply conditions and coating time) of examples 7 to 9 and comparative examples 5 and 6 are shown in table 4 below. In addition, table 4 also records the characteristics of the film under different coating conditions (film thickness, hardness and light transmittance).

**Table 2**

| | | | Comparative example 5 | Example 7 | Example 8 | Example 9 | Comparative example 6 |
|---|---|---|---|---|---|---|---|
| **Coating condition** | Gas | | C₂H₂+H₂ | C₂H₂+H₂ | C₂H₂+H₂ | C₂H₂+H₂ | C₂H₂+H₂ |
| | Gas pressure (mTorr) | | 5 | 25 | 50 | 100 | 300 |
| | Gas flow (SCCM) | C₂H₂ | 100 | 100 | 100 | 100 | 100 |
| | | H₂ | 100 | 100 | 100 | 100 | 100 |
| | High voltage pulse power supply | Voltage (V) | 900 | 900 | 900 | 900 | 900 |
| | | duty cycle (%) | 10 | 10 | 10 | 10 | 10 |
| | | Frequency (KHz) | 80 | 80 | 80 | 80 | 80 |
| | Radio frequency power supply | Power (W) | 300 | 300 | 300 | 300 | 300 |
| | Coating time (min) | | - | 1 | 1 | 1 | - |
| Film characteristic s | Film thickness (nm) | | - | 25 | 45 | 15 | - |
| | Hardness (Mohs hardness) | | - | 7 | 7 | 6-7 | - |
| | Transmittance (%) | | - | 93 | 91 | 91 | - |
| | Wear resistance times | | - | 90000 | 75000 | 50000 | - |

In this series of embodiments, in comparative examples, the bias voltage value is set to 900v and the radio frequency power is 300W. The experiment is carried out by setting different chamber pressures.

From the data in the table, it can be seen that by using the coating apparatus of the present disclosure, a film layer with qualified performance can be obtained by reasonably setting other parameters within a certain chamber air pressure range. The chamber pressure is directly related to the glow phenomenon, thus affecting the film-forming rate and film quality. If the air pressure is too low, the collision probability of particles is low, so the ionization rate is low. If the air pressure is too high, the collision probability of particles is high, and the energy loss of charged particles is too much, thus the quality of the obtained film will be reduced. From example 7, it can be seen that the coating with high light transmittance and high hardness can be obtained by appropriate process parameters.

Comparing example 5 and comparative examples 1 to 4, it can be found that when other parameters are certain, too high or too low gas pressure will lead to failure of glow start, so it is important to set the chamber pressure reasonably.

It will be appreciated by those skilled in the art that the embodiments of the present disclosure described above and shown in the accompanying drawings are illustrative only and do not limit the present disclosure. The objects of the present disclosure have been completely and effectively realized. The function and structural principle of the present disclosure have been shown and explained in the embodiments, and any variations or modifications of the embodiments of the present disclosure are possible without departing from the principles of the present disclosure.

## Claims

1. A DLC (Diamond-like Carbon) preparation apparatus, comprising:
a main body having a reaction chamber for accommodating a substrate;
a plasma source device; and
at least one gas supply device for providing a reaction gas to the reaction chamber, wherein the plasma source device is disposed outside the main body to provide a radio frequency electric field to the reaction chamber to promote a generation of plasma, so that the reaction gas can be deposited on a surface of the substrate by a Plasma Enhanced Chemical Vapor Deposition (PECVD) process to form a DLC film.

2. The DLC preparation apparatus according to claim 1, further comprising a radio frequency power supply, wherein the radio frequency power supply is electrically coupled with the plasma source device to provide power for the plasma source device.

3. The DLC preparation apparatus according to claim 1, wherein the plasma source device comprises a gas inlet frame, an isolation plate and an induction coil, the gas inlet frame is sealingly disposed outside the main body, and the isolation plate is disposed between the gas inlet frame and the induction coil.

4. The DLC preparation apparatus according to claim 3, wherein the gas inlet frame comprises a communicating channel for communicating the reaction chamber of the main body with the gas supply device.

5. The DLC preparation apparatus according to claim 4, wherein the gas inlet frame comprises at least one communicating hole and a main channel, the main body comprises a window communicated with the reaction chamber, and the window of the main body is communicated with the communicating hole and the main channel of the gas inlet frame to form the communicating channel.

6. The DLC preparation apparatus according to claim 5, wherein the communicating hole and the main channel are disposed perpendicular to each other.

7. The DLC preparation apparatus according to claim 4, wherein the gas inlet frame comprises at least one communicating hole, an inner communicating channel, a gas distribution hole and a main channel, the at least one communicating hole is communicated with the outside for inputting gases, the gas distribution hole is disposed in an inner side of the gas inlet frame and communicated with the main channel, the inner communicating channel is communicated with the communicating hole and the gas distribution hole, and an window of the main body, the communicating hole of the gas inlet frame, the inner communicating channel, the gas distribution hole and the main channel are communicated to form the communicating channel.

8. The DLC preparation apparatus according to claim 7, wherein a plurality of inner communicating channels are communicated to form an inner ring channel.

9. The DLC preparation apparatus according to claim 3, wherein the plasma source device further comprises an outer cover plate, and the induction coil is clamped between the isolation plate and the outer cover plate.

10. The DLC preparation apparatus according to claim 9, wherein the gas inlet frame comprises a main frame body and a plug-in assembly, the main frame body is sealingly disposed outside the main body, the plug-in assembly is disposed outside the main frame body, and the isolation plate, the induction coil and the outer cover plate are inserted into the plug-in assembly.

11. The DLC preparation apparatus according to claim 3, wherein the isolation plate is a ceramic sealing plate.

12. The DLC preparation apparatus according to claim 1, wherein the plasma source device comprises a radio frequency inductively coupled plasma source for providing an inductive coupling electric field.

13. The DLC preparation apparatus according to any one of claims 1 to 12, wherein the DLC preparation apparatus comprises at least one placement electrode plate and a pulse power supply, the placement electrode plate is accommodated in the reaction chamber, the placement electrode plate is electrically coupled with the pulse power supply for providing a pulse electric field to the reaction chamber, and the substrate is disposed on the placement electrode plate.

14. The DLC preparation apparatus according to claim 13, wherein the placement electrode plate is provided with a gas hole for communicating both sides of the placement electrode plate.

15. The DLC preparation apparatus according to claim 13, wherein a plurality of placement electrode plates are disposed parallel to and spaced apart from each other.

16. The DLC preparation apparatus according to claim 13, wherein a voltage of the pulse power supply ranges from - 200V to - 5000v.

17. The DLC preparation apparatus according to any one of claims 1 to 12, wherein the gas supply device comprises a plasma source supply device for providing a plasma source gas to the reaction chamber to activate a PECVD reaction.

18. The DLC preparation apparatus according to claim 17, wherein the plasma source gas includes one or more selected from a group consisting of inert gas, nitrogen and fluorocarbon gas.

19. The DLC preparation apparatus according to any one of claims 1 to 12, wherein the gas supply device comprises a reaction gas raw material supply part, and the reaction gas raw material supply device is configured to provide a hydrocarbon gas (CₓH_{y}) to the reaction chamber, so that the hydrocarbon gas (CₓH_{y}) can be deposited on the surface of the substrate by the PECVD process to form the diamond-like carbon film.

20. The DLC preparation apparatus according to any one of claims 1 to 12, wherein the gas supply device comprises an auxiliary gas supply device, and the auxiliary gas supply device provides an auxiliary gas to the reaction chamber to adjust a C-H content in the diamond-like carbon film, and to react with the hydrocarbon gas (CₓH_{y}) to deposit on the surface of the substrate to form the diamond-like carbon film.

21. The DLC preparation apparatus according to claim 20, wherein the auxiliary gas comprises one or more selected from a group consisting of nitrogen, hydrogen and fluorocarbon gas.

22. The DLC preparation apparatus according to any one of claims 1 to 12, further comprising a temperature detection device, and the temperature detection device is disposed at an equivalent position of the substrate.

23. A DLC (Diamond-like Carbon) film preparation method, comprising:
providing a reaction gas to a reaction chamber, and
promoting the reaction gas to deposit on a surface of a substrate in the reaction chamber by a Plasma Enhanced Chemical Vapor Deposition (PECVD) to form a DLC film under an action of a radio frequency electric field and a pulse electric field.

24. The DLC film preparation method according to claim 23, wherein the radio frequency electric field is turned on before the pulse electric field is turned on.

25. The DLC film preparation method according to claim 23, wherein the radio frequency electric field is disposed outside the pulse electric field.

26. The DLC film preparation method according to claim 23, wherein the radio frequency electric field is an inductive coupling electric field.

27. The DLC film preparation method according to any one of claims 23 to 26, further comprising: providing a plasma source gas to the reaction chamber to activate a PECVD reaction, wherein the radio frequency electric field and the pulse electric field act on the plasma source gas at the same time.

28. The DLC film preparation method according to any one of claims 23 to 26, further comprising: providing an auxiliary gas to the reaction chamber to adjust a C-H content in the diamond-like carbon film, and to react with a hydrocarbon gas (CₓH_{y}) to deposit on the surface of the substrate to form the DLC film.

29. The DLC film preparation method according to any one of claims 23 to 26, wherein a placement electrode plate is disposed in the reaction chamber, and the placement electrode plate is electrically coupled with a pulse power supply to provide the pulse electric field to the reaction chamber.

30. The DLC film preparation method according to any one of claims 23 to 26, further comprising: detecting a temperature at an equivalent position of the substrate for a feedback control.

31. A DLC (Diamond-like Carbon) film preparation method, comprising:
(a) providing a plasma source gas into a reaction chamber loaded with a substrate;
(b) turning on a pulse power supply and a radio frequency power supply to provide a radio frequency electric field and a pulse electric field respectively so as to activate the plasma source gas to generate plasma; and
(c) providing a hydrocarbon gas (CₓH_{y}) to the reaction chamber to deposit a DLC film on a surface of the substrate.

32. The DLC film preparation method according to claim 31, wherein in step (b), the radio frequency electric field is turned on before the pulse electric field is turned on.

33. The DLC film preparation method according to claim 31, wherein the radio frequency electric field is disposed outside the pulse electric field.

34. The DLC film preparation method according to claim 31, wherein the radio frequency electric field is an inductive coupling electric field.

35. The DLC film preparation method according to any one of claims 31 to 34, wherein step (c) comprises: providing an auxiliary gas to the reaction chamber to adjust a C-H content in the diamond-like carbon film, and to react with the hydrocarbon gas (CₓH_{y}) to deposit on the surface of the substrate to form the DLC film.

36. The DLC film preparation method according to claim 35, further comprising: pumping gases in the reaction chamber to adjust a gas pressure in the reaction chamber.

37. The DLC film preparation method according to claim 35, further comprising: detecting a temperature at an equivalent position of the substrate for a feedback control.
